# EUROPEAN PATENT APPLICATION

(11) **EP 4 089 483 A1**
(43) Date of publication of application: **16.11.2022**
(21) Application number: 21173464.5
(22) Date of filing: 12.05.2021
(51) Int. Cl.: G03F 7/20

(54) **APPARATUS FOR CONDITIONING AND DIRECTING A RADIATION BEAM**

(71) Applicant: ASML Netherlands B.V., 5500 AH Veldhoven (NL)
(72) Inventor: DER KINDEREN, Ronny, 5500 AH Veldhoven (NL); VAN SCHOOT, Jan Bernard Plechelmus, 5500 AH Veldhoven (NL); VAN SLUISVELD, Wouterus Jozephus Johannes, 5500 AH Veldhoven (NL)
(74) Representative: ASML Netherlands B.V.

(57) **Abstract**

An apparatus for conditioning and directing a radiation beam comprises: a first optical component; and an energy sensor. The first optical component comprises a two-dimensional array of independently movable reflective optical elements which is arranged to receive radiation from a radiation source. The two-dimensional array of independently movable reflective optical elements comprises: a first set configured to direct a first portion of received radiation to the energy sensor; and a second set configured to direct a second portion of received radiation to an illumination region. A number of reflective optical elements in the first set may be such that an energy of the first portion of radiation is less than 4% of the total energy of the first and second portions of radiation. The reflective optical elements in the first set of reflective optical elements may be distributed evenly over the first optical component.

## Description

### FIELD

The present invention relates to an apparatus that may be used for conditioning, directing and monitoring a radiation beam. The apparatus may form part of a lithographic apparatus, for example at least some of the apparatus may form part of an illumination system of a lithographic apparatus. The apparatus may be suitable for receiving and directing extreme ultraviolet (EUV) radiation. The present invention also relates to corresponding methods for conditioning, directing and monitoring a radiation beam. Such methods may form part of a lithographic process and/or may form part of a method of forming a pattern on a target region of a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It is desirable to provide control over various properties of a radiation beam that is used in a lithographic apparatus to project a pattern onto a substrate. For example, it is desirable to monitor an energy of the radiation beam to allow control over a dose of radiation that is delivered to the substrate. Furthermore, it is desirable to provide control over the shape (i.e. the spatial distribution) of the radiation beam in a plane of the patterning device. In addition, it is desirable to provide control over the angular distribution of the radiation beam in a plane of the patterning device. The angular distribution of the radiation beam in a plane of the patterning device may be referred to as an illumination mode this may be chosen in dependence on the pattern being imaged to increase image contrast on the substrate.

It may be desirable to provide new, alternative apparatus and/or methods for conditioning, directing and monitoring a radiation beam (for example in a lithographic apparatus) that at least partially addresses one or more problems associated with prior art arrangements whether identified herein or otherwise.

### SUMMARY

According to a first aspect of the present disclosure there is provided an apparatus comprising: a first optical component comprising a two-dimensional array of independently movable reflective optical elements which is arranged to receive radiation from a radiation source; and a sensor operable to determine an intensity of radiation received thereby; wherein the two-dimensional array of independently movable reflective optical elements comprises: a first set of reflective optical elements configured to direct a first portion of radiation received by said first set to the sensor; and a second set reflective optical elements configured to direct a second portion of radiation received by said second set to an illumination region; and wherein a number of reflective optical elements in the first set is such that an energy of the first portion of radiation is less than 4% of the total energy of the first and second portions of radiation.

The first optical component may form part of an illumination system of a lithographic apparatus. The apparatus may be suitable for receiving and directing extreme ultraviolet (EUV) radiation. For example, the first optical component may form a field facet mirror of an illumination system of a lithographic apparatus. In use, a patterning device (for example a reticle or mask) may be disposed in the illumination region. For example, during a scanning lithographic exposure, the patterning device may be moved through the illumination region. An image of the patterning device may be formed on a target region of a substrate (for example using projection optics) using the second portion of radiation.

The apparatus may in principle be retrofit to existing lithographic systems.

The apparatus according to the first aspect allows the second portion of radiation to be used for projecting a pattern onto a target portion of a substrate and, simultaneously, for an intensity or energy of the first portion of the radiation to be measured using the sensor. From the measured intensity or energy of the first portion of the radiation, an intensity or energy of the second portion of the radiation can be determined, which allows a dose of radiation delivered to a target portion of a substrate to be controlled accurately. The apparatus according to the first aspect is advantageous because it allows for such accurate dose control while reducing the amount of radiation that is used for the intensity or energy measurement (and therefore increasing the amount of radiation that is used for the exposure) relative to existing arrangements.

In some embodiments, a number of reflective optical elements in the first set may be such that an energy of the first portion of radiation is less than 2.5% of the total energy of the first and second portions of radiation. In some embodiments, a number of reflective optical elements in the first set may be such that an energy of the first portion of radiation is less than 1 % of the total energy of the first and second portions of radiation. In some embodiments, a number of reflective optical elements in the first set may be such that an energy of the first portion of radiation is less than 0.5% of the total energy of the first and second portions of radiation. In some embodiments, a number of reflective optical elements in the first set may be such that an energy of the first portion of radiation is of the order of 0.1% of the total energy of the first and second portions of radiation.

Embodiments provide a significant improvement over existing lithographic illumination systems, which may direct between 5% and 10% of the total radiation to an energy sensor. In part, this reduction in the amount of radiation used for the energy measurement is a result of using a two-dimensional array of independently movable reflective optical elements.

Furthermore, such a reduction in the amount of EUV radiation directed to the sensor is feasible for current sensor technology. Currently, a reticle level EUV energy sensor may comprise a filter to filter out any out-of-band radiation. The filter may also comprise an element (formed from aluminium) that is arranged to reduce the intensity of the EUV radiation to bring it within a dynamic range of the photosensitive part of the sensor. Currently, such EUV radiation is attenuated by a factor of -100, for example from 10% to 0.1%. Therefore, by adapting the filter stack in an energy sensor to reduce the thickness of the EUV blocking element (or removing this completely) it would be feasible to make a measurement with 0.1% of the radiation received by the apparatus.

It is estimated that an adequate energy measurement may be achieved using -0.1% of an EUV radiation beam. This is a factor 50x less than is currently used in EUV lithographic scanners. One advantage of this lower intensity of radiation being directed to an energy sensor is that it will reduce secondary electron emission from such sensors, leading to improved (linearity) performance. Together with reduced filter stack and optimized electronics and gain setting, extremely low EUV intensity levels can be sufficient while still ensuring measurement accuracy.

Advantageously, this significant power gain (of the order of -5% of EUV radiation power) of radiation in the second portion of radiation which is used for exposure is expected to result in a significant throughput gain. It is also estimated that the first aspect will result in a dose control improvement and, as a result, an improvement in critical dimension uniformity.

In some embodiments, a number of reflective optical elements in the first set may be optimized such that the amount of radiation received by the first set of reflective optical elements is minimized while allowing a total intensity of radiation received by the second set of reflective optical element to be determined with an desired accuracy.

According to a second aspect of the present disclosure there is provided an apparatus comprising: a first optical component comprising a two-dimensional array of independently movable reflective optical elements which is arranged to receive radiation from a radiation source; and a sensor operable to determine an intensity of radiation received thereby; wherein the two-dimensional array of independently movable reflective optical elements comprises: a first set of reflective optical elements configured to direct a first portion of radiation received by said first set to the sensor; and a second set of reflective optical elements configured to direct a second portion of radiation received by said second set to an illumination region such that the radiation from the second set of reflective optical elements overlaps at the illumination region so as to substantially cover the illumination region a first number of times; and wherein a number of reflective optical elements in the first set is equal to or greater than the first number.

It will be appreciated that the second aspect may be combined with the first aspect. For example, a number of reflective optical elements in the first set may be such that an energy of the first portion of radiation is less than 4% of the total energy of the first and second portions of radiation.

The second set of reflective optical elements is configured to direct the second portion of radiation to an illumination region such that the radiation from the second set of reflective optical elements overlaps at the illumination region so as to substantially cover the illumination region a first number of times. For example, the two-dimensional array of independently movable reflective optical elements may comprise a first number of groups, each of which substantially covers the illumination region and contributes to the second set of reflective optical elements. Each group may comprise a cluster of adj acent reflective optical elements. The apparatus according to the second aspect may ensure that at least one reflective optical element from each of these groups contributes to the first set which is directed to the sensor. This may ensure that each group which contributes to a dose of radiation delivered to the illumination region is sampled in the measurement of the energy or intensity of the radiation, which may ensure that the measurement of the energy or intensity of the first portion of radiation is an accurate estimate of the energy or intensity of the second portion of radiation.

In some embodiments, the number of reflective optical elements in the first set may be equal to an integer multiple of the first number. For example, in some embodiments and integer number (for example 1, 2, 3...) of reflective optical elements from each of these groups contributes to the first set which directs the first portion of radiation to the sensor.

According to a third aspect of the present disclosure there is provided an apparatus comprising: a first optical component comprising a two-dimensional array of independently movable reflective optical elements which is arranged to receive radiation from a radiation source; and a sensor operable to determine an intensity of radiation received thereby; wherein the two-dimensional array of independently movable reflective optical elements comprises: a first set of reflective optical elements configured to direct a first portion of radiation received by said first set to the sensor; and a second set of reflective optical elements configured to direct a second portion of radiation received by said second set to an illumination region; and wherein the reflective optical elements in the first set of reflective optical elements are distributed evenly over the first optical component.

It will be appreciated that the third aspect may be combined with the first and second aspects. For example, a number of reflective optical elements in the first set may be such that an energy of the first portion of radiation is less than 4% of the total energy of the first and second portions of radiation.

Advantageously, since the reflective optical elements in the first set of reflective optical elements are distributed evenly over the first optical component, the sampling of the radiation beam at the first optical component may be improved relative to the sampling provided by the energy sensors and field facet mirrors of existing lithographic illumination systems. Such existing lithographic illumination systems only sample regions of the field facet mirrors that are not used for exposure to of a substrate. In contrast, the apparatus according to the third aspect may be arranged to sample (smaller) regions of the field facet mirrors that are not used for exposure of a substrate which but which are surrounded by reflective optical elements that are. As a result, the apparatus according to the third aspect may provide a more accurate determination of the energy of the radiation that is used for exposure and/or provide information about variations in the energy of the radiation across the illumination region.

Each position in the illumination region may receive radiation from a plurality of reflective optical elements in the second set of reflective optical elements.

The illumination region may be referred to as an illumination field or an object field. The first optical component may comprise of the order of 100,000 independently movable reflective optical elements. Each position in the illumination region may receive radiation from of the order of 100 independently movable reflective optical elements.

The two-dimensional array of independently movable reflective optical elements may comprise a plurality of groups. Each group may comprise a plurality of adjacent independently movable reflective optical elements, and said plurality of adjacent independently movable reflective optical elements may comprise: a first sub-group of reflective optical elements configured to direct radiation received by said first sub-group to the sensor; and a second sub-group of reflective optical element configured to direct radiation received by said second sub-group to the illumination region.

Each of the plurality of groups of reflective optical elements may be referred to as a cluster of reflective optical elements.

The radiation directed by the second sub-groups of different groups of reflective optical elements to the illumination region may overlap spatially at the illumination region.

Each of the plurality of sub-groups may be referred to as a field facet mirror or a virtual field facet mirror. There may be of the order of 100, for example 300, groups of independently movable reflective optical elements. Each group may comprise of the order of 1000 independently movable reflective optical elements. For example, in one embodiment each group may comprise 10 rows of independently movable reflective optical elements, each row having 100 independently movable reflective optical elements. The first sub-group of each group may comprise of the order of 1 reflective optical element. The remainder of the independently movable reflective optical elements in each group may form the second sub-group.

In some embodiments, the plurality of adjacent independently movable reflective optical elements in each group may substantially cover a continuous region of the first optical component. It will be appreciated that this may mean that any gaps between adjacent reflective optical elements may be minimal.

A shape of a continuous region of the first optical component covered by the plurality of adjacent independently movable reflective optical elements in a group of independently movable reflective optical elements may be referred to as a shape of that group of independently movable reflective optical elements. The shape of each of the groups of independently movable reflective optical elements may generally correspond to a shape of the illumination region.

Each of the plurality of groups of independently movable reflective optical elements may have substantially the same size and shape.

In some embodiments, the shape of each of the plurality of groups may be curved. In some embodiments, each of the plurality of groups may be generally rectangular in shape.

In some embodiments, the plurality of groups of movable reflective optical elements may substantially cover a region of the first optical component that in use receives radiation. It will be appreciated that this may mean that any gaps between adjacent groups of reflective optical elements within the region of the first optical component that in use receives radiation may be minimal.

The first sub-group of reflective optical elements from different groups of reflective optical elements may be disposed in different positions within the groups.

For example, in embodiments wherein the independently movable reflective optical elements of each group are arranged in a plurality of rows and columns, the first sub-group of reflective optical elements (that are configured to direct radiation received from a radiation source to the sensor) from any two different groups may be disposed in different rows and/or columns within their group.

Advantageously, such an arrangement may reduce the effect of a subset of the independently movable reflective optical elements of each group being directed towards the sensor. By removing the elements of the first sub-set from different parts of the group, different regions of the illumination region are effected. In addition, ensuring that the first sub-group of reflective optical elements from different groups of reflective optical elements are disposed in different positions within the groups may allow for intensity variations within the illumination region to be determined and/or for a slit profile to be sampled or measured. As used herein, the illumination region may also be referred to as the illumination slit or the slit. Furthermore, as used herein a spatial intensity distribution of radiation across the illumination region may be referred to as the slit profile. It may be particularly beneficial for the elements of the first sub-set from all of the groups to coincide with positions that are distributed over the illumination region in a non-scanning direction of the apparatus.

The apparatus may further comprise a second optical component configured to receive radiation from the second set of reflective optical elements and to direct it to the illumination region.

The second optical component may be configured to form an image of the second sub-group of each of the plurality of groups in the illumination region, all such images overlapping spatially at the illumination region.

The second optical component may comprise a plurality of optical elements disposed at different positions along an optical axis of the apparatus.

The second optical component may be a facet mirror comprising a plurality of facets.

The second optical component may form part of an illumination system of a lithographic apparatus. For example, the second optical component may form a pupil facet mirror of an illumination system of a lithographic apparatus.

In use, the first and second optical components may, together, be configured to condition a radiation beam before that radiation beam is incident upon a patterning device disposed in the illumination region. The first and second optical components may together provide the radiation beam with a desired cross-sectional shape and a desired spatial and angular distribution. The illumination system may include other mirrors or devices in addition to the first and second optical components.

The sensor may be disposed on or connected to the second optical component.

That is, the sensor may be disposed on the pupil facet mirror inside an illumination system of a lithographic apparatus.

Each of the independently movable reflective optical elements may comprise a micro-electromechanical system (MEMS) micro-mirror.

Therefore, the first optical component may be considered to comprise a MEMS micro-mirror array.

The apparatus may further comprise a controller that is operable to control a position and/or an orientation of each of the independently movable reflective optical elements.

Therefore, the controller may be operable to configure the orientations of the independently movable reflective optical elements so as to direct a portion of received radiation to the sensor and another portion of received radiation to the illumination region.

Therefore, the controller may be operable to configure the orientations of the independently movable reflective optical elements so as to direct a portion of received radiation to the sensor and another portion of received radiation to the illumination region.

The sensor is operable to determine an intensity of radiation received thereby. In particular, the sensor is operable to determine the intensity of radiation directed thereto by the first set of reflective optical elements. The sensor may be operable to output a signal indicative of the intensity of radiation received thereby. Said signal may be received by a controller.

It will be appreciated that the sensor may use any available photosensitive technology. For example the sensor may comprise one or more of any of the following: photodiodes, complementary metal-oxide semiconductors (CMOS) and/or charged-coupled devices (CCDs).

The controller may be operable to periodically and temporarily control a position and/or an orientation of the independently movable reflective optical elements so as to position them in a second configuration.

For example, during exposure of a target region of a substrate, the controller may be operable to control the reflective optical elements so as to position them in a first configuration. The first configuration may be referred to as an exposure configuration. In the first configuration, the controller may position the reflective optical elements such that: (a) an energy of the first portion of radiation is less than a threshold percentage of the total energy of the first and second portions of radiation (as in the first aspect); (b) the amount of radiation received by the first set of reflective optical elements is minimized while allowing a total intensity of radiation received by the second set of reflective optical element to be determined with a certain accuracy (as in the second aspect); and/or (c) the reflective optical elements in the first set of reflective optical elements are distributed evenly over the first optical component (as in the third aspect).

When the independently movable reflective optical elements are in the second configuration, an energy of the first portion of radiation may be greater than it is when the independently movable reflective optical elements are in the first configuration.

For example, a more accurate and/or detailed measurement of the energy of the radiation and/or a spatial distribution of the radiation in the exposure region may be made by putting the independently movable reflective optical elements in the second configuration. This is achieved by increasing the number of reflective optical elements in the first set. The independently movable reflective optical elements may be put in the second configuration for this purpose when the apparatus is not exposing a target region of a substrate to radiation. That is, this may be done outside of the standard lot exposures in a lithographic apparatus (for example during reticle exchange, wafer exchange or in between exposure of different target regions).

In addition, the independently movable reflective optical elements may be put in the second configuration during an initial system setup and/or calibration of the apparatus.

The sensor may comprise an array of sensing elements. Each sensing element may be arranged to receive radiation from a position on the first optical component that corresponds to a different position within the illumination region.

For example, each sensing element may be arranged to receive radiation from a different position within one of the groups of independently movable reflective optical elements.

The array of sensing elements may be a one-dimensional or two-dimensional array.

Advantageously, this allows slit uniformity within the illumination region and its drift to be measured. This may avoid the need for slit scans at wafer level. Furthermore, it may enable combined reproducibility and slit uniformity corrections and may allow imaging performance to be monitored at a much higher frequency than is currently possible via slit scans at wafer level. In turn, this may result in largely improved performance and also throughput gain.

The apparatus may further comprise a radiation source operable to generate a pulsed radiation beam and to supply said pulsed radiation beam to the first optical component.

The radiation beam may comprise EUV radiation. The radiation source may be a laser produced plasma (LPP) source, a discharge produced plasma (DPP) source, a free electron laser (FEL) or any other radiation source that is capable of generating EUV radiation.

A pulse of the pulsed radiation beam may be generated by the radiation source in dependence on an intensity determined by the sensor upon receipt of a portion of a previous pulse of radiation.

For example, the sensor may determine, for example pulse-by-pulse, an energy of the radiation beam and this may be used as part of a feed-back loop to stabilize an energy of the radiation beam.

A pulse of the pulsed radiation beam may be generated by the radiation source in dependence on spatial intensity information determined by the sensor upon receipt of a portion of a previous pulse of radiation.

That is, the apparatus may feedback slit profile information determined by the sensor array per pulse to the radiation source. In particular, this data not only provides intensity information to secure dose reproducibility, but in addition can provide information on slit uniformity and far field stability. For an LPP source, such information would allow the radiation source to optimize and stabilize a laser beam to droplet alignment, thereby further improving slit uniformity and far field stability.

The sensor may be operable to quantify an alignment between the first optical component and a radiation beam received thereby.

The apparatus may further comprise a support structure configured to support a patterning device such that the patterning device is disposed in, or movable through, the illumination region and wherein the sensor may be disposed proximate to the support structure.

That is, the sensor may be provided at reticle level.

The apparatus may further comprise: a substrate table configured to support a substrate; and a projection system comprising imaging optics configured to receive radiation from the illumination region and to form an image of an object disposed in the illumination region on a substrate supported by the substrate table.

For example, the object may comprise a patterning device supported by the support structure. The radiation beam may interacts with the patterning device so as to generate a patterned radiation beam. The projection system is configured to project the patterned radiation beam onto the substrate. For that purpose, the imaging optics may comprise a plurality of mirrors which are configured to project the patterned radiation beam onto a substrate held by the substrate table.

The sensor may be disposed between the imaging optics and the substrate table.

That is, the sensor may be provided at substrate or wafer level. For example, the sensor may be provided proximate to a dynamic gas lock that is located between the optics of the projection system and the substrate. With such an arrangement, the sensor may be operable to measure the intensity and uniformity of the radiation beam after the whole optical column (illumination system and projection system). This would enable additional real time and highly accurate system transmission measurements and dose reproducibility corrections.

System transmission measurement and/or monitoring improvement may result in more accurate diagnostics, reducing unscheduled down time and increasing availability of the lithographic apparatus.

According to a fourth aspect of the present disclosure there is provided a lithographic apparatus or a lithographic system comprising the apparatus of any one of the first, second or third aspects of the present disclosure.

According to a fifth aspect of the present disclosure there is provided a method of forming a pattern on a target region of a substrate, the method comprising: producing a radiation beam; directing the radiation beam to a first optical component comprising a two-dimensional array of independently movable reflective optical elements, the two-dimensional array of independently movable reflective optical elements comprising a first set of reflective optical elements and a second set of reflective optical elements; directing a first portion of the radiation beam to a sensor using the first set of reflective optical elements and determining an intensity of the first portion of the radiation beam using the sensor; and directing a second portion of the radiation beam to a reticle using the second set of reflective optical elements so as to impart a pattern to the second portion of the radiation beam and form a patterned radiation beam; and projecting the patterned radiation beam onto the target region of a substrate; wherein an energy of the first portion of radiation is less than 4% of the total energy of the first and second portions of radiation.

The method according to the fifth aspect may be implemented using an apparatus according to the first aspect.

According to a sixth aspect of the present disclosure there is provided a method of forming a pattern on a target region of a substrate, the method comprising: producing a radiation beam; directing the radiation beam to a first optical component comprising a two-dimensional array of independently movable reflective optical elements, the two-dimensional array of independently movable reflective optical elements comprising a first set of reflective optical elements and a second set of reflective optical elements; directing a first portion of the radiation beam to a sensor using the first set of reflective optical elements and determining an intensity of the first portion of the radiation beam using the sensor; and directing a second portion of the radiation beam to a reticle using the second set of reflective optical elements so as to impart a pattern to the second portion of the radiation beam and form a patterned radiation beam; and projecting the patterned radiation beam onto the target region of a substrate; wherein the second portion comprises a plurality of spatially overlapping contributions each originating from a group of adjacent reflective optical elements; and wherein the first set comprises one or more reflective optical elements from each of said plurality of groups.

The method according to the sixth aspect may be implemented using an apparatus according to the second aspect.

The first set may comprise an integer number of reflective optical elements from each of said plurality of groups.

It may be desirable to minimize the integer number. For example, the integer number may be a small integer number, for example 1, 2 or 3.

According to a seventh aspect of the present disclosure there is provided a method of forming a pattern on a target region of a substrate, the method comprising: producing a radiation beam; directing the radiation beam to a first optical component comprising a two-dimensional array of independently movable reflective optical elements, the two-dimensional array of independently movable reflective optical elements comprising a first set of reflective optical elements and a second set of reflective optical elements; directing a first portion of the radiation beam to a sensor using the first set of reflective optical elements and determining an intensity of the first portion of the radiation beam using the sensor; and directing a second portion of the radiation beam to a reticle using the second set of reflective optical elements so as to impart a pattern to the second portion of the radiation beam and form a patterned radiation beam; and projecting the patterned radiation beam onto the target region of a substrate; wherein the first portion is formed from a plurality of samples of the radiation beam distributed evenly over the radiation beam.

The method according to the seventh aspect may be implemented using an apparatus according to the third aspect.

The method of any of the fifth, sixth or seventh aspects may further comprise determining a spatial distribution of the radiation beam at the patterning device using the sensor.

The method of any of the fifth, sixth or seventh aspects may comprise sequentially forming a pattern on a plurality of target regions of one or more substrates.

The method may further comprise periodically determining a more accurate and/or more detailed measurement of the energy of the radiation beam and/or a spatial distribution of the radiation beam at the patterning device in between exposure of different target regions.

The radiation beam may be a pulsed radiation beam and a pulse of the pulsed radiation beam may be generated in dependence on an intensity determined by the sensor upon receipt of a portion of a previous pulse of radiation.

A pulse of the pulsed radiation beam may be generated in dependence on spatial intensity information determined by the sensor upon receipt of a portion of a previous pulse of radiation.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of the lithographic system shown in Figure 1, showing a central obscuration portion and two portions which receive radiation;
- Figure 2B shows an example shape of a field facet for a faceted field mirror device in a known EUV lithographic apparatus of the form shown in Figure 1;
- Figure 3 is a schematic diagram of an apparatus for conditioning, directing and monitoring a radiation beam according to an embodiment of the present invention;
- Figure 4 is a schematic diagram of a variant of the apparatus shown in Figure 3;
- Figure 5 is a schematic diagram showing some of the functionality of a controller that may form part of the apparatus shown in Figure 3 or Figure 4; and
- Figure 6 is a schematic diagram of a method according to an embodiment of the present invention.

### DETAILED DESCRIPTION

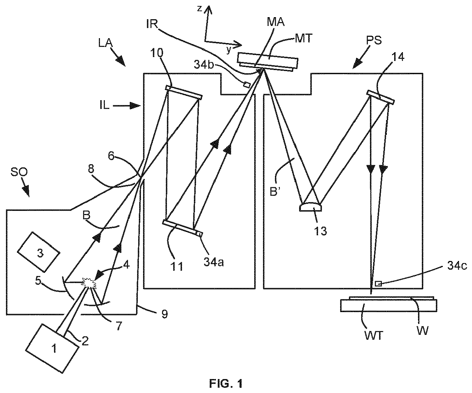

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

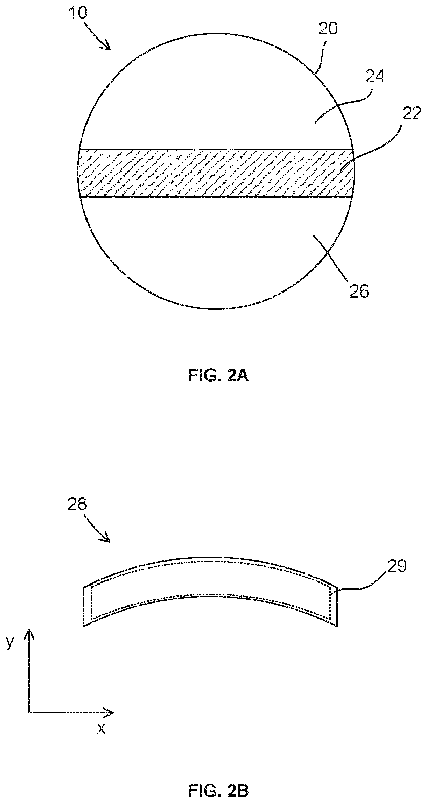

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A known faceted field mirror device 10 used in an EUV lithographic apparatus of the type shown in Figure 1 is now described with reference to Figures 2A and 2B.

In known EUV lithographic apparatus, the faceted field mirror device 10 comprises a plurality of field facets. In particular, in such known EUV lithographic apparatus, the portions 24, 26 of the faceted field mirror device 10 that receive radiation from the radiation source SO are provided with a plurality of field facets. For example, the portions 24, 26 of the faceted field mirror device 10 that receive radiation from the radiation source SO may be provided with of the order of 100 field facets (for example 300 field facets). In a plane of the faceted field mirror device 10 each field facet may have a curved shape 28, as shown in Figure 2B. In general, in the plane of the faceted field mirror device 10 each field facet may have an elongate shape having a longer dimension in an x-direction and a shorter dimension in a y-direction. Each field facet comprises a mirror that may be arranged to image the intermediate focus 6 onto the faceted pupil mirror device 11. To achieve this, the field facets may, for example, be concave.

The faceted pupil mirror device 11 comprises a plurality of pupil facets. The faceted pupil mirror device 11 is arranged to project an image of each field facet of the faceted field mirror device 10 onto an illumination region IR (also referred to as the slit or illumination slit) at the patterning device MA. The illumination system IL is configured so that each field facet is imaged on the illumination region IR in an overlapping manner. Desirably, each image of a field facet fills the illumination region IR. The overlap of the images of the field facets at least partially evens out irregularities in the radiation beam B provided by the radiation source SO.

The illumination region IR may be curved or straight. In general, in a scanning lithographic apparatus LA, the illumination region IR is elongate having a longer dimension and a shorter dimension. The shorter dimension may coincide with a scanning direction of the support structure MT and the longer dimension may coincide with a non-scanning direction. The illumination region IR may be curved or straight. The illumination region IR is indicated in Figure 1, which shows the patterning device in cross section. The longer dimension (in the x-direction) of the illumination region IR is perpendicular to the plane of Figure 1 and the shorter dimension (in the y-direction) of the illumination region IR lies in the plane of Figure 1.

It will be appreciated that the illumination region IR may have a shape in the plane of the patterning device MA that generally corresponds to that of each of the field facets, for example being generally of the form of the shape 28 shown in Figure 2B. Note that the shape and size of each field facet may not be exactly the same as the illumination region IR and depends on the magnification factors applied in the x and y directions by the field facet, the pupil facets (and any other optics in upstream of the illumination region IR). The edges of the illumination region IR may be defined by two sets of reticle masking blades (not shown), which may truncate the radiation such that radiation is not incident on the patterning device outside of the illumination region IR. Therefore, each of the field facets may be arranged such that in the absence of such reticle masking blades they would each overfill the illumination region IR. The illumination region IR may receive radiation from a central portion of each field facet, as indicated by the dotted line 29 inside the example shape 28 of a field facet shown in Figure 2B.

Therefore, in some existing EUV lithographic apparatus, a region surrounding the illumination region IR is also provided with EUV radiation (although the illumination region at the patterning device MA is masked from this portion of the EUV radiation, which is not used for exposing the substrate W). This region surrounding the illumination region IR may receive EUV radiation from an edge portion of each field facet mirror (which may be the portion disposed between the dotted line 29 and the edge of shape in the schematic illustration in Figure 2B). At least a part of this portion of the EUV radiation that is not used for exposing the substrate W may be incident on an energy sensor, which may be used to monitor and control a dose of radiation that is delivered to the substrate W. Typically, such known lithographic illumination systems, may direct between 5% and 10% of the total radiation to the region between the dotted line 29 and the edge of shape in the schematic illustration in Figure 2B).

It has been proposed to use a faceted field mirror device 10 having a large number of individually directable or movable reflective optical elements so as to provide better control over the illumination modes of the lithographic apparatus.

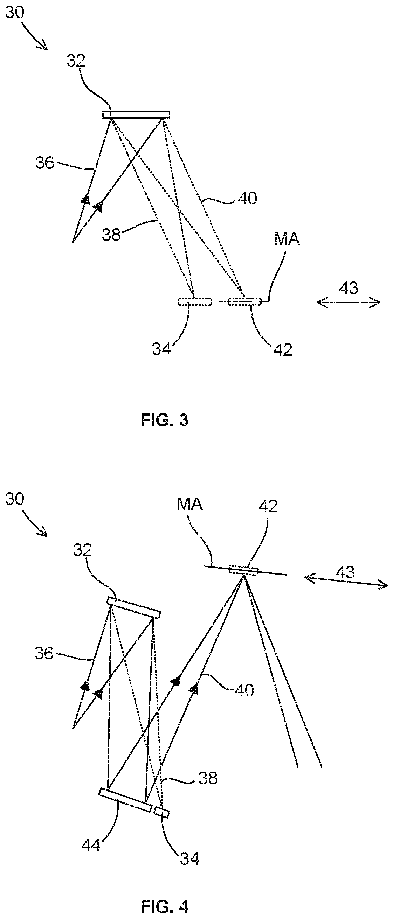

Embodiments of the present invention may comprise a faceted field mirror device 10 comprising a two-dimensional array of independently movable reflective optical elements. In particular, embodiments of the present invention may exploit the additional flexibility provided by a faceted field mirror device 10 comprising a two-dimensional array of independently movable reflective optical elements, so as to optimize and/or improve a measurement of the energy and/or intensity of the radiation that may be used for dose control, as now discussed with reference to Figures 3 to 6.

Figure 3 is a schematic diagram of an apparatus 30 for conditioning, directing and monitoring a radiation beam according to an embodiment of the present invention. The apparatus 30 comprises a first optical component 32 and a sensor 34.

The first optical component 32 comprises a two-dimensional array of independently movable reflective optical elements which is arranged to receive radiation 36 (for example from a radiation source). Each of the independently movable reflective optical elements comprises a micro-electromechanical system (MEMS). Therefore, the first optical component 32 may be considered to comprise a MEMS micro-mirror array.

Each of the reflective optical elements may, for example, be a multilayer mirror. Each of the reflective optical elements may be configured such that its orientation can be controlled about one or two axes so that a position to which it directs radiation can be controlled. For example, each of the reflective optical elements may have one or more actuators by which the reflective optical element can be rotated about an axis or two orthogonal axes. Thereby, each of the reflective optical elements can be controlled to direct radiation in a specific direction.

Optionally, each of the reflective optical elements may be configured such that it can be set to an inactive state in which it directs radiation received from the intermediate focus 6 in a direction such that the radiation does not reach the illumination region IR. For example, radiation from reflective optical elements set to an inactive state may be directed to a beam dump to absorb it.

The sensor 34 is operable to determine an intensity of radiation received thereby. The sensor 34 may be referred to as an energy sensor or an intensity sensor. It will be appreciated that the sensor 34 may use any available photosensitive technology. For example the sensor 34 may comprise one or more of any of the following: photodiodes, complementary metal-oxide semiconductors (CMOS) and/or charged-coupled devices (CCDs).

As will be discussed further below, the two-dimensional array of independently movable reflective optical elements comprises a first set of reflective optical elements and a second set of reflective optical elements.

The first set of reflective optical elements is configured to direct a first portion of radiation 38 received thereby to the sensor 34. The second set of reflective optical elements is configured to direct a second portion of radiation 40 received thereby to an illumination region 42.

The first optical component 32 may form part of an illumination system IL of a lithographic apparatus LA of the type shown in Figure 1 and described above. The apparatus 30 may be suitable for receiving and directing extreme ultraviolet (EUV) radiation. For example, the first optical component may form a field facet mirror device 10 of an illumination system IL of a lithographic apparatus LA. In use, a patterning device MA (for example a reticle or mask) may be disposed in the illumination region 42. For example, during a scanning lithographic exposure, the patterning device MA may be moved through the illumination region 42 in a scanning direction, as schematically indicated by arrow 43. An image of the patterning device MA may be formed on a target region of a substrate W (for example using projection optics PS) using the second portion of radiation 40.

The apparatus 30 shown in Figure 3 allows the second portion of radiation 40 to be used for projecting a pattern onto a target portion of a substrate W and, simultaneously, for an intensity or energy of the first portion of the radiation 38 to be measured using the sensor 34. From the measured intensity or energy of the first portion of the radiation 38, an intensity or energy of the second portion of the radiation 40 can be determined, which allows a dose of radiation delivered to a target portion of a substrate W to be controlled accurately.

As shown in Figure 4, optionally, the apparatus 30 may further comprise a second optical component 44 configured to receive the second portion of radiation 40 (from the second set of reflective optical elements) and to direct it to the illumination region 42. The second optical component 44 may be a facet mirror device comprising a plurality of facets. For example, the second optical component 44 may form part of an illumination system IL of a lithographic apparatus LA. For example, the second optical component 44 may form a pupil facet mirror device 11 of an illumination system IL of a lithographic apparatus LA of the type shown in Figure 1 and described above.

In use, the first and second optical components 32, 44 may, together, be configured to condition a radiation beam 36 before that radiation beam is incident upon a patterning device MA disposed in the illumination region 42. The first and second optical components 32, 44 may together provide the radiation beam with a desired cross-sectional shape and a desired spatial and angular distribution. It will be appreciated that such an illumination system may include other mirrors or devices in addition to the first and second optical components. To effect a desired illumination mode, the orientations of the reflective optical elements of the first optical component 32 may be controlled to direct radiation to selected pupil facets of the second optical component 44. Some pupil facets may receive radiation from more than one reflective optical element; other pupil facets may receive no radiation. This arrangement can be used to effect a large number of different illumination modes.

Optionally, as shown in Figure 4, in some embodiments the sensor 34 may be disposed on or connected to the second optical component 44. In some embodiments, the sensor 34 may be disposed on the pupil facet mirror device 11 inside an illumination system IL of a lithographic apparatus LA, as indicated schematically in Figure 1 by box 34a.

Alternatively, in some embodiments the sensor 34 may be disposed proximate to the support structure MT, as indicated schematically in Figure 1 by box 34b. In such an arrangement the sensor 34 may be described as being at reticle level. With such an arrangement, the sensor 34 may be disposed in a position that corresponds to a region surrounding the illumination region IR that receives EUV radiation from an edge portion of each field facet mirror (which may be the portion disposed between the dotted line 29 and the edge of shape in the schematic illustration in Figure 2B).

Alternatively, in some embodiments the sensor 34 may be disposed proximate to the substrate table WT. For example, the sensor 34 may be disposed between the imaging optics 13, 14 within the projection system PS and the substrate table WT, as indicated schematically in Figure 1 by box 34c. In such an arrangement the sensor 34 may be described as being provided at substrate or wafer level. For example, the sensor 34 may be provided proximate to a dynamic gas lock. With such an arrangement, the sensor 34 may be operable to measure the intensity and uniformity of the patterned radiation beam B' after the whole optical column. Advantageously, this would enable additional real time and highly accurate system transmission measurements and dose reproducibility corrections. Such system transmission measurements and/or monitoring improvements may result in more accurate diagnostics, reducing unscheduled down time of the lithographic apparatus LA and increasing availability of the lithographic apparatus LA.

In some embodiments, each position in the illumination region IR may receive radiation from a plurality of the reflective optical elements in the second set of reflective optical elements, as now discussed.

The first optical component 32 may comprise of the order of 100,000 independently movable reflective optical elements. These reflective optical elements may substantially cover the portions 24, 26 of the faceted field mirror device 10 that receive radiation from the radiation source SO (see Figure 2A and accompanying discussion). Each position in the illumination region IR may receive radiation from of the order of 100 independently movable reflective optical elements, as now discussed further.

In some embodiments, the two-dimensional array of independently movable reflective optical elements provided on the faceted field mirror device 10 may be considered to comprise a plurality of groups of reflective optical elements. Each group of reflective optical elements may comprise a plurality of adjacent independently movable reflective optical elements on the faceted field mirror device 10. Each of the plurality of groups of reflective optical elements may be referred to as a cluster of reflective optical elements.

Each group of reflective optical elements may be configured generally to replace one of the field facets discussed above. For example, each group may cover a region of the faceted field mirror device 10 that generally corresponds to the shape of a field facet of an existing faceted field mirror device 10 (for example a region having a shape generally the same as the shape 28 shown in Figure 2B). It will be appreciated that each of the reflective optical elements may be generally square or rectangular in shape and therefore if the group is arranged as a generally curved elongate region of the faceted field mirror device 10 (similar to the shape 28 shown in Figure 2B), the shape may have jagged or pixelated edges along the curved sides of the shape. Furthermore, the orientations of the reflective optical elements within each group may be configured so as to provide an equivalent optical power or concave shape to a field facet of an existing faceted field mirror device 10.

Each group of reflective optical elements may comprise: a first sub-group of reflective optical elements configured to direct radiation received by said first sub-group to the sensor 34; and a second sub-group of reflective optical element configured to direct radiation received by said second sub-group to the illumination region 42. In some embodiments, the first sub-group may comprise a single reflective optical element or a small number of reflective optical elements.

Furthermore, the radiation directed by the second sub-groups from each of different groups of reflective optical elements to the illumination region 42 overlaps spatially at the illumination region 42 (in a similar manner to the overlap of each image of the field facets described above).

Each of the plurality of groups may be referred to as a field facet mirror or a virtual field facet mirror. There may be of the order of 100, for example 300, groups of independently movable reflective optical elements. Each group may comprise of the order of 1000 independently movable reflective optical elements. For example, in one embodiment each group may comprise 10 rows of independently movable reflective optical elements, each row having 100 independently movable reflective optical elements. The first sub-group of each group may comprise of the order of 1 reflective optical element. The remainder of the independently movable reflective optical elements in each group may form the second sub-group.

In some embodiments, the plurality of adjacent independently movable reflective optical elements in each group may substantially cover a continuous region of the first optical component 32. It will be appreciated that this may mean that any gaps between adjacent reflective optical elements may be minimal.

A shape of a continuous region of the first optical component covered by the plurality of adjacent independently movable reflective optical elements in a group of independently movable reflective optical elements may be referred to as a shape of that group of independently movable reflective optical elements. The shape of each of the groups of independently movable reflective optical elements may generally correspond to a shape of the illumination region IR (in a similar manner to the shape of each of the field facets described above generally corresponding to a shape of the illumination region IR).

Each of the plurality of groups of independently movable reflective optical elements may have substantially the same size and shape. In some embodiments, the shape of each of the plurality of groups may be curved. In some embodiments, each of the plurality of groups may be generally rectangular in shape.

In some embodiments, the plurality of groups of movable reflective optical elements may substantially cover a region of the first optical component 32 that in use receives radiation. The region of the first optical component 32 that in use receives radiation may, for example, may substantially cover the portions 24, 26 of a faceted field mirror device 10 that receive radiation from the radiation source SO. It will be appreciated that this may mean that any gaps between adjacent groups of reflective optical elements within the region of the first optical component that in use receives radiation may be minimal.

In some embodiments, the first sub-group of reflective optical elements from different groups of reflective optical elements may be disposed in different positions within the groups.

For example, in embodiments wherein the independently movable reflective optical elements of each group are arranged in a plurality of rows and columns, the first sub-group of reflective optical elements (that are configured to direct radiation received from a radiation source to the sensor) from any two different groups may be disposed in different rows and/or columns within their group. For example, In embodiments wherein each group covers a region of the faceted field mirror device 10 that generally corresponds to the shape of a field facet of an existing faceted field mirror device 10 (for example a region having a shape generally the same as the shape 28 shown in Figure 2B), the first sub-group of reflective optical elements from different groups may be disposed in different positions within said shape 28. Advantageously, such an arrangement may reduce the effect of a subset of the independently movable reflective optical elements of each group being directed towards the sensor 34 (as opposed to the illumination region 42). By removing the elements of the first sub-set from different parts of the different groups, a plurality of different regions of the illumination region 42 are affected. In addition, ensuring that the first sub-group of reflective optical elements from different groups of reflective optical elements are disposed in different positions within the groups may allow for intensity variations within the illumination region to be determined and/or for a slit profile to be sampled or measured. It may be particularly beneficial for the elements of the first sub-set from all of the groups to coincide with positions that are distributed over the illumination region in a non-scanning direction of the apparatus (for example, the x-direction in the Figures).

In some embodiments, the second optical component 44 may be configured to form an image of the second sub-group of each of the plurality of groups in the illumination region IR, all such images overlapping spatially at the illumination region IR.

In some embodiments, the second set of reflective optical elements is configured to direct the second portion of radiation 40 received by said second set to the illumination region 42 such that the radiation from the second set of reflective optical elements overlaps at the illumination region 42 so as to substantially cover the illumination region 42 a first number n₁ of times. For example, the first number n₁ may correspond to the number of groups of reflective optical elements (each group generally replacing a field facet mirror). For such embodiments, a number of reflective optical elements in the first set is equal to or greater than the first number n₁. The first number n₁ may be of the order of 100, for example 300.

The second set of reflective optical elements is configured to direct the second portion of radiation 40 to the illumination region 42 such that the radiation from the second set of reflective optical elements overlaps at the illumination region 42 so as to substantially cover the illumination region 42 a first number n₁ of times. For example, the two-dimensional array of independently movable reflective optical elements may comprise a first number n₁ of groups, each of which substantially covers the illumination region 42 and contributes to the second set of reflective optical elements. As explained above, each group may comprise a cluster of adjacent reflective optical elements. The apparatus 30 may ensure that at least one reflective optical element from each of these groups (that are all imaged onto the illumination region 42) contributes to the first set which is directed to the sensor. This may ensure that each group which contributes to a dose of radiation delivered to the illumination region 42 is sampled in the measurement of the energy or intensity of the radiation, which may ensure that the measurement of the energy or intensity of the first portion of radiation is an accurate estimate of the energy or intensity of the second portion of radiation.

In some embodiments, the number of reflective optical elements in the first set may be equal to an integer multiple of the first number n₁ (which may be the number of groups of reflective optical elements that each generally replaces a field facet mirror). For example, in some embodiments and integer number (for example 1, 2, 3...) of reflective optical elements from each of these groups contributes to the first set which directs the first portion of radiation to the sensor.

In some embodiments, a number of reflective optical elements in the first set is such that an energy of the first portion of radiation is less than 4% of the total energy of the first and second portions of radiation. For such embodiments, the apparatus 30 shown in Figure 3 is advantageous because it allows for such accurate dose control while reducing the amount of radiation that is used for the intensity or energy measurement (and therefore increasing the amount of radiation that is used for the exposure) relative to existing arrangements.

In some embodiments, a number of reflective optical elements in the first set may be such that an energy of the first portion of radiation is less than 1 % of the total energy of the first and second portions of radiation. In some embodiments, a number of reflective optical elements in the first set may be such that an energy of the first portion of radiation is of the order of 0.1% of the total energy of the first and second portions of radiation.

Therefore, the apparatus 30 shown in Figure 3 can provide a significant improvement over existing lithographic illumination systems, which may direct between 5% and 10% of the total radiation to an energy sensor (for example, by providing radiation to the entire region between the dotted line 29 and the edge of shape in the schematic illustration in Figure 2B). In part, this reduction in the amount of radiation used for the energy measurement is a result of using a two-dimensional array of independently movable reflective optical elements.

Furthermore, such a reduction is feasible for current sensor technology. Currently, a reticle level EUV energy sensor comprises a filter to filter out any out-of-band radiation. The filter also comprises an element (formed from aluminium) that is arranged to reduce the intensity of the EUV radiation to bring it within a dynamic range of the photosensitive part of the sensor. Currently, the EUV radiation is attenuated by a factor of -100, for example from 10% to 0.1%. Therefore, by adapting the filter stack in energy sensor to reduce the thickness of the EUV blocking element (or removing this completely) it would be feasible to make a measurement with 0.1% of the radiation.

Therefore, it is estimated that an adequate energy measurement may be achieved using -0.1% of an EUV radiation beam. This is a factor 50x less than is currently used in EUV lithographic scanners. One advantage of this lower intensity of radiation being directed to an energy sensor is that it will reduce secondary electron emission from such sensors, leading to improved (linearity) performance. Together with reduced filter stack and optimized electronics and gain setting, extremely low EUV intensity levels can be sufficient while still ensuring measurement accuracy.

Advantageously, this significant power gain (of the order of -5% of EUV radiation power) of radiation in the second portion of radiation which is used for exposure is expected to result in a significant throughput gain. It is also estimated that the first aspect will result in a dose control improvement and, as a result, an improvement in critical dimension uniformity.

In some embodiments, a number of reflective optical elements in the first set may be optimized such that the amount of radiation received by the first set of reflective optical elements is minimized while allowing a total intensity of radiation received by the second sub-group of reflective optical element to be determined with a desired accuracy.

In some embodiments, the reflective optical elements in the first set of reflective optical elements are distributed evenly over the first optical component 32. Advantageously, since the reflective optical elements in the first set of reflective optical elements are distributed evenly over the first optical component, the sampling of the radiation beam 36 at the first optical component by the sensor 34 may be improved relative to the sampling provided by the energy sensors and field facet mirrors of existing lithographic illumination systems. Such existing lithographic illumination systems only sample regions of the field facet mirror device 10 that are not used for exposure to of a substrate W. In contrast, embodiments of the apparatus 30 shown in Figure 3 may be arranged to sample (smaller) regions of the field facet mirror device 10 that are not used for exposure of a substrate which but which are surrounded by reflective optical elements that are. That is, rather than only sampling an entire edge portion of each field facet mirror (which may be the portion disposed between the dotted line 29 and the edge of shape in the schematic illustration in Figure 2B), embodiments of the present invention may be arranged to sample smaller regions (for example using a single MEMS mirror) within a region of the field facet mirror device 10 that is being used for exposure of a substrate W. As a result, embodiments of the present invention may provide a more accurate determination of the energy of the radiation that is used for exposure and/or provide information about variations in the energy of the radiation across the illumination region 42.

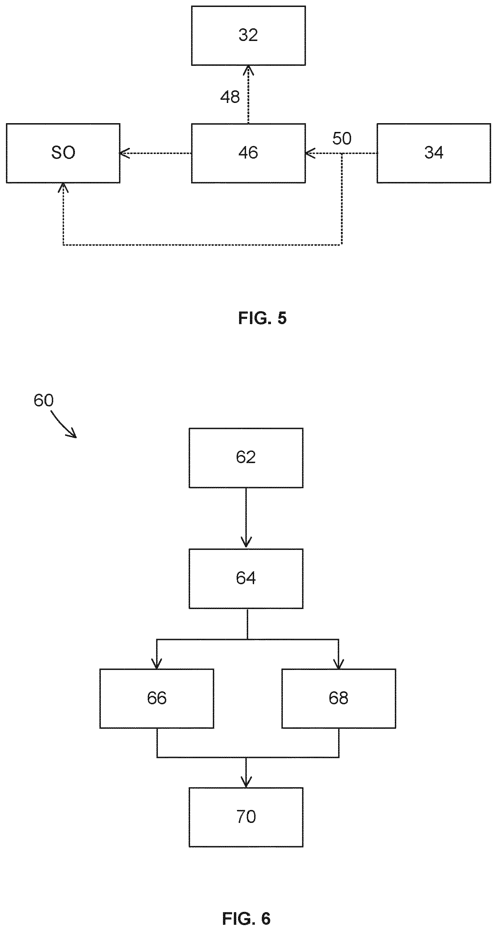

In some embodiments, the apparatus may further comprise a controller 46 that is operable to control a position and/or an orientation of each of the independently movable reflective optical elements, as now discussed with reference to Figure 5. Figure 5 is a schematic diagram showing some of the functionality of the controller 46 that may form part of the apparatus 30 shown in Figure 3 or Figure 4. The controller 46 may be operable to configure the orientations of the independently movable reflective optical elements so as to direct a portion 38 of received radiation to the sensor 34 and another portion 40 of received radiation to the illumination region 42. To achieve this, the controller 46 may be operable to send a suitable control signal 48 to the first optical component 32.

The sensor 34 may be operable to determine an intensity of radiation received thereby. In particular, the sensor 34 is operable to determine the intensity of radiation directed thereto by the first set of reflective optical elements. The sensor may be operable to output a signal 50 indicative of the intensity of radiation received thereby. Said signal 50 indicative of the intensity of radiation received by the sensor 34 may be received by the controller 46.

In some embodiments, the apparatus 30 has a plurality of configurations, which may be controlled using the controller 46, as now discussed.

For example, during exposure of a target region of a substrate W, the controller 46 may be operable to control the reflective optical elements so as to position them in a first configuration, which has been discussed above. The first configuration may be referred to as an exposure configuration. In the first configuration, the controller 46 may position the reflective optical elements such that: (a) an energy of the first portion of radiation 38 is less than a threshold percentage of the total energy of the first and second portions of radiation 38, 40; (b) the amount of radiation received by the first set of reflective optical elements is minimized while allowing a total intensity of radiation received by the second sub-group of reflective optical elements to be determined with a certain accuracy; and/or (c) the reflective optical elements in the first set of reflective optical elements are distributed evenly over the first optical component 32.

In some embodiments, the controller 46 may be operable to periodically and temporarily control a position and/or an orientation of the independently movable reflective optical elements of the first optical component 32 so as to position them in a second configuration. When the independently movable reflective optical elements are in the second configuration, an energy of the first portion of radiation 38 is greater than it is when the independently movable reflective optical elements are in the first configuration.

For example, a more accurate and/or detailed measurement of the energy of the radiation and/or a spatial distribution of the radiation in the exposure region 42 may be made by putting the independently movable reflective optical elements are in the second configuration. This is achieved by increasing the number of reflective optical elements in the first set. The independently movable reflective optical elements may be put in the second configuration for this purpose when the apparatus 30, LA is not exposing a target region of a substrate W to radiation. That is, this may be done outside of the standard lot exposures in a lithographic apparatus LA (for example during reticle exchange, wafer exchange or in between exposure of different target regions).

In addition, the independently movable reflective optical elements may be put in the second configuration during an initial system setup and/or calibration of the apparatus.

In some embodiments, the sensor 34 may comprise an array of sensing elements, each sensing element being arranged to receive radiation from a position on the first optical component 32 that corresponds to a different position within the illumination region 42. For example, each sensing element may be arranged to receive radiation from a different position within one of the groups of independently movable reflective optical elements. For such embodiments, a signal 50 output by the sensor 34 may be indicative of an intensity distribution of radiation across the illumination region 42.

The array of sensing elements may be a one-dimensional or two-dimensional array.

Advantageously, this allows slit uniformity within the illumination region IR and its drift to be measured. This may avoid the need for slit scans at wafer level. Furthermore, it may enable combined reproducibility and slit uniformity corrections and may allow imaging performance to be monitored at a much higher frequency than is currently possible via slit scans at wafer level. In turn, this may result in largely improved performance and also throughput gain.

In some embodiments, a signal 50 output by the sensor 34, which may be indicative of the intensity of radiation received thereby may be received by the radiation source SO (either directly or indirectly via the controller 46). In response thereto, a pulse of a pulsed radiation beam B generated by the radiation source SO may be generated in dependence on an intensity determined by the sensor 34 upon receipt of a portion of a previous pulse of radiation B. For example, the sensor 34 may determine, for example pulse-by-pulse, an energy of the radiation beam B and this may be used as part of a feedback loop to stabilize an energy of the radiation beam generated by the radiation source SO.

As discussed above, in some embodiments the sensor 34 is operable to determine spatial intensity information (for example if the sensor 34 comprises a sensor array). For such embodiments, the signal 50 output by the sensor 34 may also be indicative of an intensity distribution of radiation across the illumination region 42. For such embodiments, a pulse of the pulsed radiation beam B generated by the radiation source SO may be generated in dependence on spatial intensity information determined by the sensor 34 upon receipt of a portion of a previous pulse of radiation. That is, the apparatus 30 may feedback slit profile information determined by the sensor array 34 per pulse to the radiation source SO. In particular, this data not only provides intensity information to secure dose reproducibility, but in addition can provide information on slit uniformity and far field stability. For an LPP source (as shown in Figure 1), such information would allow the radiation source to optimize and stabilize a laser beam 2 to fuel droplet alignment (at the plasma formation region 4), thereby further improving slit uniformity and far field stability.

In some embodiments of the apparatus 30, the sensor 34 is operable to quantify an alignment between the first optical component 32 and a radiation beam B received thereby.

Figure 6 is a schematic diagram of a method 60 according to an embodiment of the present invention. The method 60 may be implemented using the apparatus 30 shown in Figures 3 and 4 and described above. It will be appreciated that the method 60 may implement any of the functionality of the apparatus 30 shown in Figures 3 and 4 and described above.

The method 60 comprises a step 62 of producing a radiation beam (for example using a radiation source SO).

Subsequently, the method 60 comprises a step 64 of directing the radiation beam to a first optical component comprising a two-dimensional array of independently movable reflective optical elements, the two-dimensional array of independently movable reflective optical elements comprising a first set of reflective optical elements and a second set of reflective optical elements.

The method 60 further comprises a step 66 of directing a first portion of the radiation beam to a sensor using the first set of reflective optical elements and determining an intensity of the first portion of the radiation beam using the sensor.

The method 60 further comprises a step 68 of directing a second portion of the radiation beam to a reticle using the second set of reflective optical elements so as to impart a pattern to the second portion of the radiation beam and form a patterned radiation beam.

It will be appreciated from Figure 6, and from the description of the apparatus 30 shown in Figures 3 and 4 above, that steps 64 and 66 may proceed in parallel.

The method 60 further comprises a step 70 of projecting the patterned radiation beam onto the target region of a substrate. The method is characterized in that it corresponds to the functionality of the apparatus 30 shown in Figures 3 and 4 and described above.

In particular, an energy of the first portion of radiation (see step 66) may be less than 4% of the total energy of the first and second portions of radiation. Furthermore, a number of reflective optical elements in the first set may be equal to or greater than a first number of times n₁ that the radiation from the second set of reflective optical elements overlaps at the illumination region so as to substantially cover the illumination region. Furthermore, the first portion may be formed from a plurality of samples of the radiation beam distributed evenly over the radiation beam at the first optical component.

The method 60 may comprise sequentially forming a pattern on a plurality of target regions of one or more substrates W. For example, the method 60 may comprise forming the pattern on a plurality of substrates W and the pattern may be formed on a plurality of target regions on each substrate W. For such embodiments, the method 60 may further comprise periodically determining a more accurate and/or more detailed measurement of the energy of the radiation beam and/or a spatial distribution of the radiation beam at the patterning device in between exposure of different target regions.

The method 60 may comprise a feedback process wherein the intensity of the first portion of the radiation beam using the sensor determined at step 66 is used to control subsequent production of radiation at step 62. The radiation beam produced at step 62 may be a pulsed radiation beam. For such embodiments, a pulse of the pulsed radiation beam generated at step 62 may be generated in dependence on an intensity determined at step 66 by the sensor upon receipt of a portion of a previous pulse of radiation.

At step 66, the method 60 may further comprise determining a spatial distribution of the radiation beam at the patterning device using the sensor. For such embodiments, a pulse of the pulsed radiation beam generated at step 62 may be generated in dependence on spatial intensity information determined at step 66 by the sensor upon receipt of a portion of a previous pulse of radiation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An apparatus comprising:
a first optical component comprising a two-dimensional array of independently movable reflective optical elements which is arranged to receive radiation from a radiation source; and
a sensor operable to determine an intensity of radiation received thereby;
wherein the two-dimensional array of independently movable reflective optical elements comprises:
a first set of reflective optical elements configured to direct a first portion of radiation received by said first set to the sensor; and
a second set reflective optical elements configured to direct a second portion of radiation received by said second set to an illumination region; and
wherein a number of reflective optical elements in the first set is such that an energy of the first portion of radiation is less than 4% of the total energy of the first and second portions of radiation.

2. An apparatus comprising:
a first optical component comprising a two-dimensional array of independently movable reflective optical elements which is arranged to receive radiation from a radiation source; and
a sensor operable to determine an intensity of radiation received thereby;
wherein the two-dimensional array of independently movable reflective optical elements comprises:
a first set of reflective optical elements configured to direct a first portion of radiation received by said first set to the sensor; and
a second set of reflective optical elements configured to direct a second portion of radiation received by said second set to an illumination region such that the radiation from the second set of reflective optical elements overlaps at the illumination region so as to substantially cover the illumination region a first number of times; and
wherein a number of reflective optical elements in the first set is equal to or greater than the first number.

3. The apparatus of claim 2 wherein a number of reflective optical elements in the first set is such that an energy of the first portion of radiation is less than 4% of the total energy of the first and second portions of radiation.

4. An apparatus comprising:
a first optical component comprising a two-dimensional array of independently movable reflective optical elements which is arranged to receive radiation from a radiation source; and
a sensor operable to determine an intensity of radiation received thereby;
wherein the two-dimensional array of independently movable reflective optical elements comprises:
a first set of reflective optical elements configured to direct a first portion of radiation received by said first set to the sensor; and
a second set of reflective optical elements configured to direct a second portion of radiation received by said second set to an illumination region; and
wherein the reflective optical elements in the first set of reflective optical elements are distributed evenly over the first optical component.

5. The apparatus of claim 4 wherein a number of reflective optical elements in the first set is such that an energy of the first portion of radiation is less than 4% of the total energy of the first and second portions of radiation.

6. The apparatus of any preceding claim wherein each position in the illumination region receives radiation from a plurality of reflective optical elements in the second set of reflective optical elements.

7. The apparatus of any preceding claim wherein the two-dimensional array of independently movable reflective optical elements comprises a plurality of groups, each group comprising a plurality of adjacent independently movable reflective optical elements, said plurality of adjacent independently movable reflective optical elements comprising:
a first sub-group of reflective optical elements configured to direct radiation received by said first sub-group to the sensor; and
a second sub-group of reflective optical element configured to direct radiation received by said second sub-group to the illumination region.

8. The apparatus of claim 7 wherein the radiation directed by the second sub-groups of different groups of reflective optical elements to the illumination region overlaps spatially at the illumination region.

9. The apparatus of claim 7 or claim 8 wherein each of the plurality of groups of independently movable reflective optical elements has substantially the same size and shape.

10. The apparatus of any one of claims to 7 to 9 wherein the first sub-group of reflective optical elements from different groups of reflective optical elements are disposed in different positions within the groups.

11. The apparatus of any preceding claim further comprising a second optical component configured to receive radiation from the second set of reflective optical elements and to direct it to the illumination region.

12. The apparatus of claim 11 when dependent on any one of claims 7 to 10 wherein the second optical component is configured to form an image of the second sub-group of each of the plurality of groups in the illumination region, all such images overlapping spatially at the illumination region.

13. The apparatus of claim 11 or claim 12 wherein the second optical component is a facet mirror comprising a plurality of facets.

14. The apparatus of any one of claims 11 to 13 wherein the sensor is disposed on or connected to the second optical component.

15. The apparatus of any preceding claim wherein each of the independently movable reflective optical elements comprises a micro-electromechanical system (MEMS) micro-mirror.

16. The apparatus of any preceding claim further comprising a controller that is operable to control a position and/or an orientation of each of the independently movable reflective optical elements.

17. The apparatus of claim 16 wherein the controller is operable to periodically and temporarily control a position and/or an orientation of the independently movable reflective optical elements so as to position them in a second configuration.

18. The apparatus of claim 17 wherein when the independently movable reflective optical elements are in the second configuration, an energy of the first portion of radiation is greater than it is when the independently movable reflective optical elements are in the first configuration.

19. The apparatus of any preceding claim wherein the sensor comprises an array of sensing elements, each sensing element arranged to receive radiation from a position on the first optical component that corresponds to a different position within the illumination region.

20. The apparatus of any preceding claim further comprising a radiation source operable to generate a pulsed radiation beam and to supply said pulsed radiation beam to the first optical component.

21. The apparatus of claim 20 wherein a pulse of the pulsed radiation beam is generated by the radiation source in dependence on an intensity determined by the sensor upon receipt of a portion of a previous pulse of radiation.

22. The apparatus of claim 20 or claim 21 when dependent on claim 19 wherein a pulse of the pulsed radiation beam is generated by the radiation source in dependence on spatial intensity information determined by the sensor upon receipt of a portion of a previous pulse of radiation.

23. The apparatus of any preceding claim wherein the sensor is operable to quantify an alignment between the first optical component and a radiation beam received thereby.

24. The apparatus of any preceding claim further comprising a support structure configured to support a patterning device such that the patterning device is disposed in, or movable through, the illumination region and wherein the sensor is disposed proximate to the support structure.

25. The apparatus of any preceding claim further comprising:
a substrate table configured to support a substrate; and
a projection system comprising imaging optics configured to receive radiation from the illumination region and to form an image of an object disposed in the illumination region on a substrate supported by the substrate table.

26. The apparatus of claim 25 wherein the sensor is disposed between the imaging optics and the substrate table.

27. A lithographic apparatus or a lithographic system comprising the apparatus of any preceding claim.

28. A method of forming a pattern on a target region of a substrate, the method comprising:
producing a radiation beam;
directing the radiation beam to a first optical component comprising a two-dimensional array of independently movable reflective optical elements, the two-dimensional array of independently movable reflective optical elements comprising a first set of reflective optical elements and a second set of reflective optical elements;
directing a first portion of the radiation beam to a sensor using the first set of reflective optical elements and determining an intensity of the first portion of the radiation beam using the sensor; and
directing a second portion of the radiation beam to a reticle using the second set of reflective optical elements so as to impart a pattern to the second portion of the radiation beam and form a patterned radiation beam; and
projecting the patterned radiation beam onto the target region of a substrate;
wherein an energy of the first portion of radiation is less than 4% of the total energy of the first and second portions of radiation.

29. A method of forming a pattern on a target region of a substrate, the method comprising:
producing a radiation beam;
directing the radiation beam to a first optical component comprising a two-dimensional array of independently movable reflective optical elements, the two-dimensional array of independently movable reflective optical elements comprising a first set of reflective optical elements and a second set of reflective optical elements;
directing a first portion of the radiation beam to a sensor using the first set of reflective optical elements and determining an intensity of the first portion of the radiation beam using the sensor; and
directing a second portion of the radiation beam to a reticle using the second set of reflective optical elements so as to impart a pattern to the second portion of the radiation beam and form a patterned radiation beam; and
projecting the patterned radiation beam onto the target region of a substrate;
wherein the second portion comprises a plurality of spatially overlapping contributions each originating from a group of adjacent reflective optical elements; and
wherein the first set comprises one or more reflective optical elements from each of said plurality of groups.

30. The method of claim 29 wherein the first set comprises an integer number of reflective optical elements from each of said plurality of groups.

31. A method of forming a pattern on a target region of a substrate, the method comprising:
producing a radiation beam;
directing the radiation beam to a first optical component comprising a two-dimensional array of independently movable reflective optical elements, the two-dimensional array of independently movable reflective optical elements comprising a first set of reflective optical elements and a second set of reflective optical elements;
directing a first portion of the radiation beam to a sensor using the first set of reflective optical elements and determining an intensity of the first portion of the radiation beam using the sensor; and
directing a second portion of the radiation beam to a reticle using the second set of reflective optical elements so as to impart a pattern to the second portion of the radiation beam and form a patterned radiation beam; and
projecting the patterned radiation beam onto the target region of a substrate;
wherein the first portion is formed from a plurality of samples of the radiation beam distributed evenly over the radiation beam.

32. The method of any one of claims 29 to 31 further comprising determining a spatial distribution of the radiation beam at the patterning device using the sensor.

33. The method of any one of claims 28 to 32 comprising sequentially forming a pattern on a plurality of target regions of one or more substrates.

34. The method of claim 33 further comprising periodically determining a more accurate and/or more detailed measurement of the energy of the radiation beam and/or a spatial distribution of the radiation beam at the patterning device in between exposure of different target regions.

35. The method of any one of claims 28 to 34 wherein the radiation beam is a pulsed radiation beam and wherein a pulse of the pulsed radiation beam is generated in dependence on an intensity determined by the sensor upon receipt of a portion of a previous pulse of radiation.

36. The method of claim 35 when dependent on claim 32 wherein a pulse of the pulsed radiation beam is generated in dependence on spatial intensity information determined by the sensor upon receipt of a portion of a previous pulse of radiation.
